# EUROPEAN PATENT APPLICATION

(11) **EP 2 058 646 A1**
(43) Date of publication of application: **13.05.2009**
(21) Application number: 07793043.6
(22) Date of filing: 28.08.2007
(51) Int. Cl.: G01N 21/956, H05K 3/00, H05K 3/34

(54) **SUBSTRATE INSPECTING APPARATUS**

(30) Priority: 28.08.2006 JP 2006231282; 28.08.2006 JP 2006230560; 28.08.2006 JP 2006230561; 28.08.2006 JP 2006230562
(71) Applicant: I-Pulse Kabushiki Kaisha, Hamamatsu-shi, Shizuoka 431-2103 (JP)
(72) Inventor: KAKUDA, Yoshihisa, Hamamatsu-shi Shizuoka 431-2103 (JP)
(74) Representative: Müller-Boré & Partner Patentanwälte
(86) International application number: PCT/JP2007/066597
(87) International publication number: WO 2008/026559

(57) **Abstract**

A board inspection device 1 comprises: an inspection unit 50 for inspecting a board P; a board-supplying unit 24 that enables a board P to be manually supplied to the inspection unit 50; and a liquid crystal monitor 4 for displaying prescribed information including the results of an inspection of the board P, wherein the board inspection device 1 is further provided with: a camera 52 for recognizing identification information assigned to the board P; and a control unit 60 that confirms inspection history of the board P based on the identification information acquired via the camera 52 and controls, when it is confirmed that the board P has already been inspected, the liquid crystal monitor 4 to display information to the effect that the board P has already been inspected and prohibits execution of an inspection operation on the board P by the inspection unit 50.

## Description

### Technical Field

The present invention relates to a board inspection device for inspecting a mounting state of parts mounted on a board, a printed wiring pattern on the board, a cream solder printing pattern on the board, and the like.

### Background Art

Conventionally, as an alternative inspection device to a so-called in-line inspection device, an outline desktop stationary type (hereinafter referred to as desktop) inspection device is known which individually inspects boards via manual operations by an operator.

For example, a desktop inspection device of this type is disclosed in Patent Document 1 described below. This inspection device comprises: a testing unit that captures an image of a board; and a main unit that performs processing such as good-bad judgment, wherein when an operator sets a board on the testing unit and issues an instruction to start an inspection, an image of a surface of the board is captured by a scanning unit mounted on the testing unit, the captured image data is transferred to the main unit, and processing such as good-bad judgment is performed based on the image data and a result of the processing is displayed on a monitor of the main unit. When the inspection of a single board is concluded in this manner, the board is replaced by the operator and a similar inspection is repeated on a new board.

However, with a desktop inspection device that is used such that a board is set to the testing unit and replaced with a next board after the test is concluded through manual operations as described above, there is a risk that the operator may once again set a board that has already been inspected onto the testing unit by mistake, and when such an event occurs, the same board ends up being redundantly inspected, creating a problem in that the operating efficiency of board inspection declines.
Patent Document 1: Japanese Patent Laid-Open No. 2002-181730

### Disclosure of the Invention

The present invention has been made in consideration of the above, and an object thereof is to provide a board inspection device capable of reliably preventing inspections from being redundantly performed on the same board.

In order to achieve the object, a board inspection device according to the present invention comprises: an inspection unit for inspecting a board; a board-supplying unit that enables a board to be manually supplied to the inspection unit; and display for displaying prescribed information including the results of the inspection of the board, wherein the board inspection device is further provided with: recognizer for recognizing identification information assigned to the board; history confirmer that acquires identification information of the board via the recognizer and confirms inspection history of the board based on the identification information; and controller that controls, when it is confirmed by the history confirmer that the board has already been inspected, the display to display information to the effect that the board has already been inspected and prohibits execution of an inspection operation on the board by the inspection unit.

According to the inspection device, a board supplied manually via the board-supplying unit is inspected by the inspection unit and a result of the inspection is displayed on the display. However, when it is confirmed that the board has already been inspected based on identification information assigned to the board, the display is controlled so as to display information to the effect that the board has already been inspected and the inspection unit is prohibited from executing an inspection operation on the board. Consequently, inspections are prevented from being redundantly performed on the same board and, as a result, board inspections can now be efficiently performed while avoiding occurrences of time loss due to redundant inspections.

### Brief Description of the Drawings

Figure 1 is a perspective view showing an inspection device according to an embodiment of the present invention;
Figure 2 is a plan view showing the inspection device;
Figure 3 is a longitudinal cross-sectional view showing an internal structure of the inspection device;
Figure 4 is a plane cross-sectional view showing an internal structure of the inspection device;
Figure 5 is a diagram extracting a portion of Figure 3 which supports a liquid crystal panel;
Figure 6 is a cross-sectional view of a base frame showing an assembly structure of a control unit;
Figure 7 is a block diagram showing a control system of the inspection device;
Figure 8 is a diagram showing an inspection completion mark and the like assigned to a board;
Figure 9A to 9C are diagrams for schematically describing contents of image processing to be performed by the inspection device, wherein 9A shows a picked-up image of a board, 9B shows standard image data, and 9C shows a difference image between 9A and 9B;
Figure 10 is a diagram showing an image displayed on a liquid crystal monitor for visual judgment by an operator;
Figure 11 is a flowchart showing contents of control operations to be executed by a control unit;
Figure 12 is a subroutine showing board inspection control performed in the flowchart shown in Figure 11; and
Figure 13 is a plan view showing a state where a plurality of inspection devices are arranged in a fan-like shape.

### Best Mode for Carrying Out the Invention

Hereinafter, a preferred embodiment of the present invention will be described in detail with reference to the accompanying drawings.

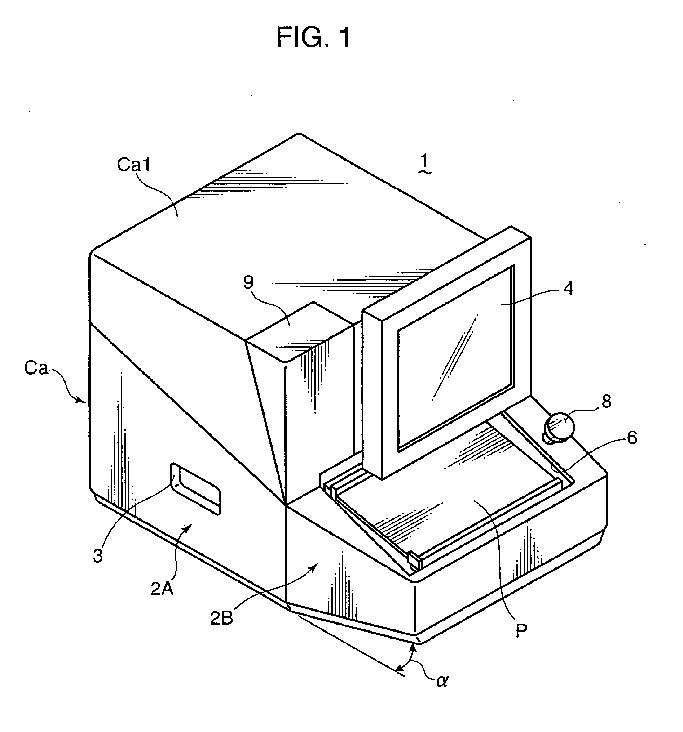

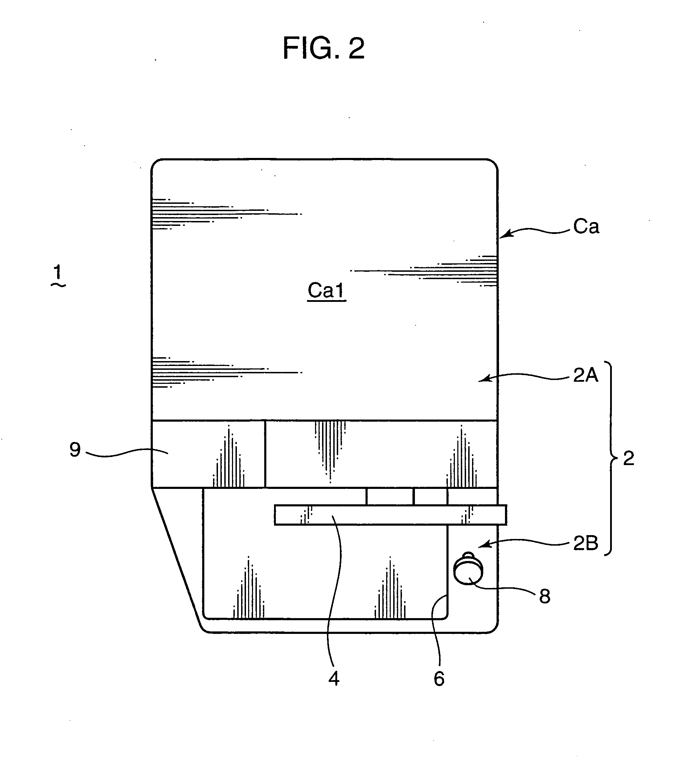

Figures 1 and 2 schematically show a board inspection device 1 according to an embodiment of the present invention. As shown in the drawings, the inspection device 1 has an L-shaped appearance as seen from a lateral perspective in which the entire inspection device 1 is shaped like a box and is provided with a rear-side portion 2A comprising a posterior side of the inspection device 1 and a front-side portion 2B that extends forward from a front end lower portion of the rear-side portion 2A. Such an appearance of the inspection device 1 is formed by a casing Ca that covers internal parts such as an inspection unit 50 to be described later.

Among the inspection device 1, the front-side portion 2B is provided with an inlet/outlet 6 which opens upward to allow a print board P to be taken out and/or put in from/to the device. The inlet/outlet 6 is composed of an opening formed on the casing Ca and is provided centrally in the width direction (in Figure 2, at the center in the left-right direction) of the inspection device 1.

A liquid crystal monitor 4 (corresponding to display according to the present invention) is placed above the inlet/outlet 6 at a front face portion of the rear-side portion 2A. The liquid crystal monitor 4 is composed of a so-called touch panel liquid crystal display, and in addition to displaying thereon various information such as inspection results, the liquid crystal monitor 4 enables input of various operations to the inspection device 1 by having an operator touch a monitor display by his/her fingertip.

A maintenance door 9 is provided at a portion aligned with the liquid crystal monitor 4 among the front-side portion 2B. The door 9 is a portion of the casing Ca configured so as to be openable/closable, and is arranged so that, by opening the door 9 as necessary, an operator can access the inside of the inspection device 1 to replace a check pen 56, to be described later, and the like. In addition, an upper face cover Ca1 among the casing Ca is arranged so as to be detachable so that maintenance of an image pickup unit 51, to be described later, and the like can be performed in a state where the upper face cover Ca1 is removed.

As shown in Figure 1, a handle 3 composed of a depression is provided at both left and right side portions of the rear-side portion 2A of the casing Ca and enables the inspection device 1 to be carried by holding the handle 3. Moreover, reference numeral 8 in Figures 1 and 2 denotes an emergency stop button placed to the side of the inlet/outlet 6.

The inspection device 1 is formed so that the width of the device tapers from the rear side towards the front side thereof. More particularly, the width of the inspection device 1 is formed tapered by inclining one of the lateral faces of the front-side portion 2B (the left lateral face in Figure 2) among the lateral faces of the inspection device 1 constituted by the casing Ca by a predetermined angle α with respect to the front-rear direction. This is a contrivance for compactly installing a plurality of the inspection devices 1 and improving workability, and will be described in detail later.

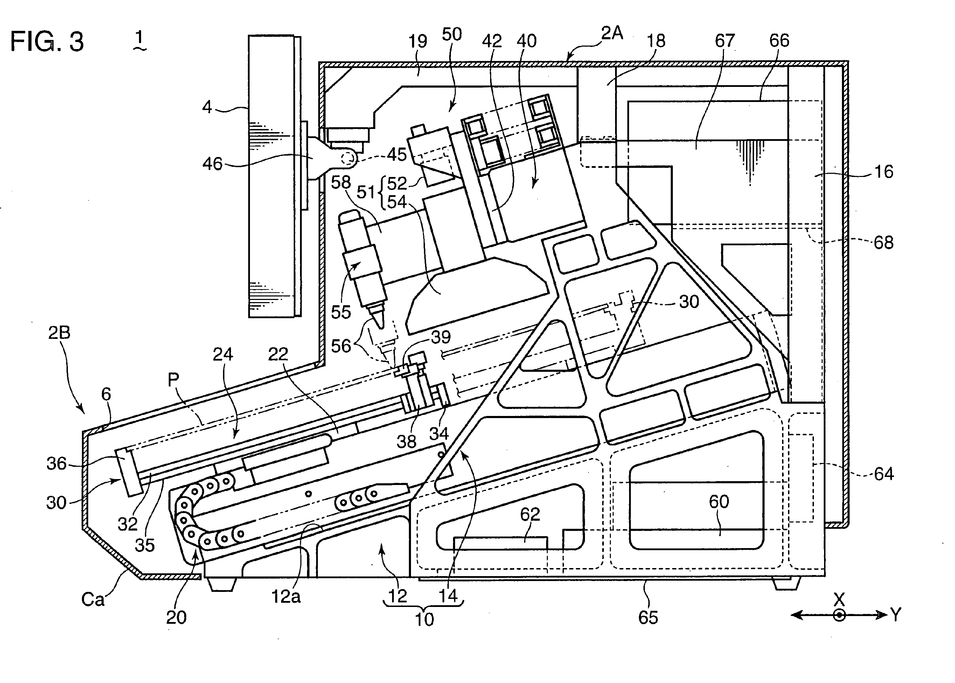

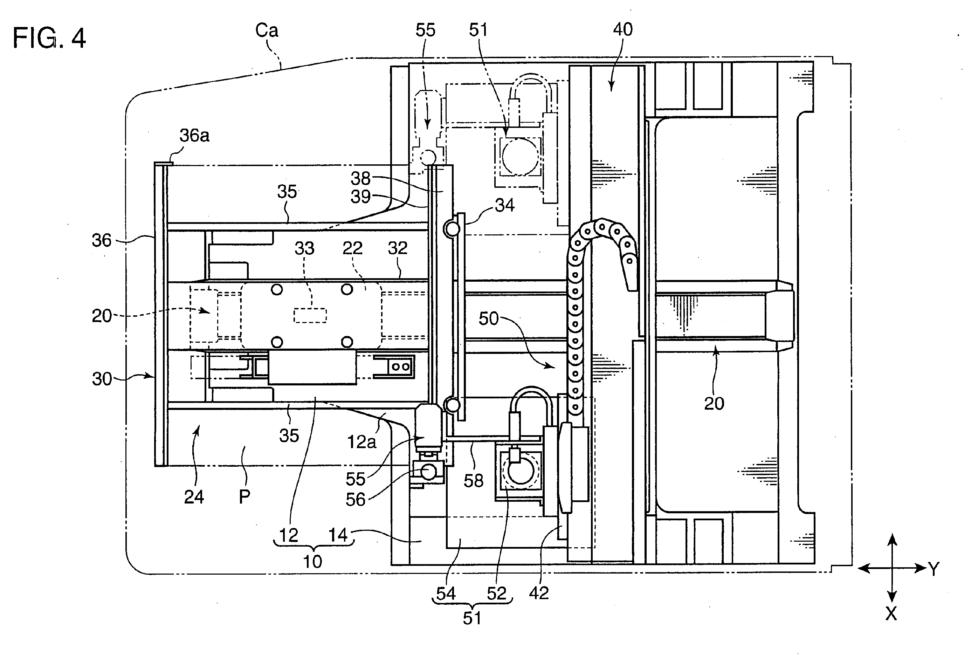

Figures 3 and 4 are diagrams for showing specific internal configurations of the inspection device 1. As shown in the drawings, a base frame 10 is provided inside the inspection device 1. Assembled on the base frame 10 are: a board-supplying unit 24 that holds and moves the print board P manually supplied through the inlet/outlet 6 by the operator; an inspection unit 50 that inspects the appearance of the print board P by picking up an image of the print board P held by the board-supplying unit 24, and the like.

The structure of the base frame 10 is integrally provided with a base portion 12 having a front-sloping inclined face 12a whose height becomes lower the further towards the front side (the side on which the liquid crystal monitor 4 is provided), and side wall portions 14 respectively rising from both left and right ends of the base portion 12. The base frame 10 is composed of a cast piece such as an aluminum die-cast piece.

The board-supplying unit 24 is composed of a linear motor-type single axis robot 20 fixed onto the inclined face 12a of the base portion 12 and which moves a slider 22 in a front-rear direction along the inclined face 12a (hereinafter, this direction shall be referred to as a Y-axis direction), and a table 30 fixed to the slider 22.

The table 30 holds the print board P. More specifically, the table 30 holds the print board P so that a face to be inspected becomes parallel with the inclined face 12a. The table 30 is configured so as to be movable, in response to the actuation of the single axis robot 20, in the Y-axis direction between a home position (the position indicated by the solid line in Figure 3) opposing the inlet/outlet 6 and an inspection position (the position indicated by the dashed-two dotted line in Figure 3) opposing the image pickup unit 51 to be described later. Attaching and/or detaching of the print board P to/from the table 30 is manually performed by the operator at the home position, whereas an image of the print board P is arranged to be picked up by the image pickup unit 51 when the table 30 has moved from the home position to the inspection position.

The table 30 includes a plate 32 fixed to an upper face portion of the slider 22 and a pair of front and rear board-holding frames 36 and 38 (hereinafter may sometimes be referred to as the front-side frame 36 and the rear-side frame 38) assembled onto the plate 32 and extending in a left-right direction. The print board P is arranged so as to be sandwiched between the frames 36 and 38. More specifically, a movable unit 39 displaceable in the Y-axis direction and biased forward by an elastic member such as a compression coil spring is provided on the rear-side frame 38 among the frames 36 and 38, and stair-shaped board receiving portions are respectively formed on portions of the movable unit 39 and the front-side frame 36 which oppose each other.
When the operator holding the print board P places front and rear edges of the print board P on the board receiving portions to fit the board P between the front-side frame 36 and the movable unit 39 (refer to Figure 3), the print board P is elastically sandwiched between both frames 36 and 38 by the elastic force of the compression coil spring or the like, and in accordance thereto, the print board P is to be held on the table 30 in a state where the print board P is positioned in the Y-axis direction with respect to the front-side frame 36. In addition, a positioning plate 36a is provided on the side of one end in the left-right direction of the front-side frame 36. By having an edge (an edge in the left-right direction) of the print board P abut the plate 36a, the plate P is positioned in the left-right direction (hereinafter referred to as an X-axis direction).

The spacing between the front-side and rear-side frames 36 and 38 is arranged so as to be variable depending on the board size. More specifically, an end plate 34 is fixed to a rear end of the plate 32, and a pair of left and right guide bars 35 that are parallel to each other is fixed across the end plate 34 and the front-side frame 36. The rear-side frame 38 is mounted so as to be slidable on the guide bars 35. The guide bars 35 are also provided with a locker, not shown, which is capable of locking the rear-side frame 38 onto the guide bars 35 at an arbitrary position. In other words, the spacing between the front-side and rear-side frames 36 and 38 is arranged so as to be variable by sliding the rear-side frame 38 with respect to the front-side frame 36 and locking the rear-side frame 38 at a desired position using the locker.

As shown in Figure 4, board detector 33 composed of an optical sensor is embedded into a plate 32 of the table 30 and detects whether or not a print board P has been set on the table 30. The present embodiment is arranged so that a detection signal of the board detector 33 has a value of ON when the print board P is set on the table 30 and a value of OFF when the print board P has not been set.

The inspection unit 50 is provided with: a single axis robot 40 that moves the slider 42 in the X-axis direction; and the image pickup unit 51 to be assembled onto the single axis robot 40 via the slider 42.

In a similar manner to the single axis robot 20 for driving the table 30, the single axis robot 40 is composed of a linear motor-type single axis robot and is fixed to the base frame 10 in a state where the single axis robot is laid laterally across both side wall portions 14.

The image pickup unit 51 is provided with: a camera 52 (corresponding to recognizer according to the present invention) including an area sensor such as a CCD, CMOS image sensor, or the like; and an illuminating device 54 that irradiates an illuminating light onto the print board P that is a subject. The image pickup unit 51 is arranged so that the camera 52 picks up an image of the print board P held on the table 30 from a direction perpendicular to the front face of the print board P.
The image pickup unit 51 is configured so as to be movable, in accordance with the movement of the slider 42 in the X-axis direction, to an image pickup position above the single axis robot 20 of the board-supplying unit 24 or to positions depicted by the dashed-two dotted line and the solid line in Figure 4. In addition, the image pickup unit 51 is held at the image pickup position during normal times and may also be moved to the position indicated by the dashed-two dotted line in Figure 4 when a marking unit 55, to be described later, is replaced or the like, or to the position indicated by the solid line in Figure 4 during maintenance of the image pickup unit 51 after removing the upper face cover Ca1, or the like.

The inspection unit 50 is mounted with the marking unit 55 (corresponding to marking device according to the present invention) which, depending on inspection results or the like, inscribes a predetermined mark onto the print board P. The marking unit 55 comprises the check pen 56 for inscribing a mark and a drive mechanism that drives the check pen 56 forward/backward, and in accordance with the actuation of the drive mechanism, the check pen 56 is arranged so as to move forward/backward between an operation position (the position indicated by the dashed-two dotted line in Figure 3) at which the check pen 56 abuts the print board P held on the table 30 and a retreat position (the position indicated by the solid line in Figure 3) to which the check pen 56 retreats upward from the operation position. Moreover, as the drive mechanism, a translation mechanism or the like is applied which moves the check pen 56 forward and/or backward in a uniaxial direction by, for example, a motor-driven ball screw.

As shown in Figures 3 and 4, the marking unit 55 is configured such that by being fixed to the image pickup unit 51 via a connecting arm 58, the marking unit 55 integrally moves with the image pickup unit 51 in the X-axis direction. The marking unit 55 is arranged so as to be positioned behind (on the rearward side) of the door 9 shown in Figures 1 and 2 at the side of one end (the position indicated by the dashed-two dotted line in Figure 4) in a movable range thereof in the left-right direction. In other words, by opening the door 9 when the marking unit 55 is placed at this position, an operator may readily replace the check pen 56 or the like.

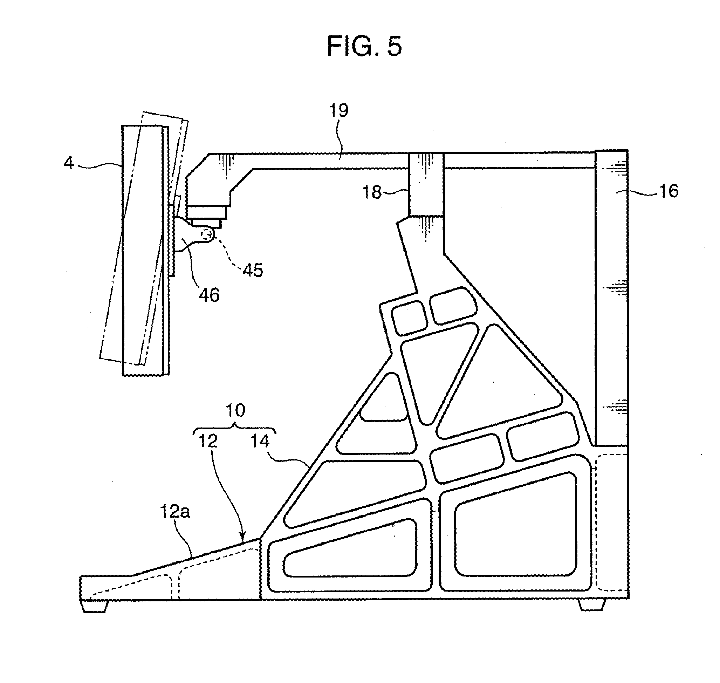

A beam 19 which extends in a front-rear direction is further provided above the base frame 10. As shown in Figure 5, the beam 19 is fixed by a pair of front and rear gate-shaped subframes 16 and 18 fixed across both side wall portions 14 of the base frame 10. The liquid crystal panel 4 is supported on a tip of the beam 19. As shown in Figure 3, the support position of the liquid crystal panel 4 in a front-rear direction is set approximately midway between the image pickup position of the board P by the image pickup unit 51 and the inlet/outlet 6, and on the front side of the image pickup unit 51.

The liquid crystal panel 4 is supported so as to be tiltable on a tip of the beam 19. More specifically, a joint 46 is connected to a front end portion of the beam 19 in a rotatable state around a spindle 45 extending in the X-axis direction, and by assembling the liquid crystal monitor 4 onto the joint 46, an inclination angle of the liquid crystal monitor 4 with respect to a vertical axis thereof is arranged so as to be variable (the posture of the liquid crystal monitor 4 can be varied in an upward-downward direction). Moreover, the liquid crystal panel 4 can also be configured so that the posture thereof can be varied in a left-right direction or in another arbitrary direction.

In addition, as shown in Figure 3, a driver 66 which controls driving of the single axis robot 40 of the inspection unit 50 is disposed in a space above the installation portion of the board-supplying unit 24 and behind the inspection unit 50. More specifically, a pair of left and right lateral plates 67 is fixed to both side wall portions 14 of the base frame 10 and to the subframe 18 and a supporting plate 68 is laid laterally across the lateral plates 67, whereby the driver 66 is fixed onto the supporting plate 68.

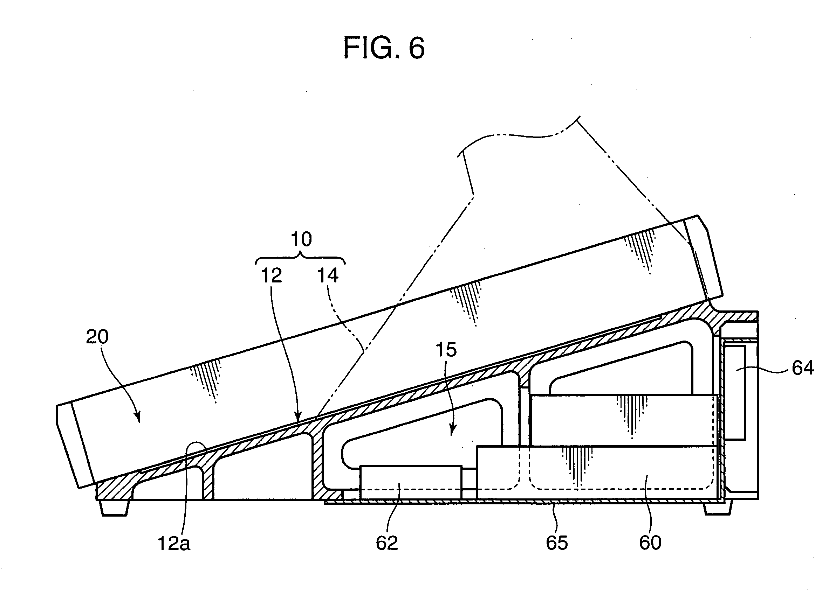

Meanwhile, a control unit 60 responsible for overall control of the inspection device 1, a driver 62 for the single axis robot 20 of the board-supplying unit 24, and the like are disposed inside the base portion 12 of the base frame 10. In other words, as shown in Figure 6, a space 15 with an approximately triangular cross-section composed of a depression which opens downward and rearward is formed inside the base portion 12, whereby the control unit 60 and the driver 62 are disposed inside the space 15. Moreover, reference numeral 64 in Figures 3 and 6 denotes a cooling fan for cooling the control unit 60 and the like.

The control unit 60, the driver 62, and the cooling fan 64 are integrally fixed to an under cover 65 primarily covering a lower face portion and a rear face portion of the inspection device 1. The respective devices 60, 62, and 64 are arranged so as to be housed in the space 15 of the base portion 12 in a state where the under cover 65 is assembled onto the base portion 12 of the base frame 10 from the underside.

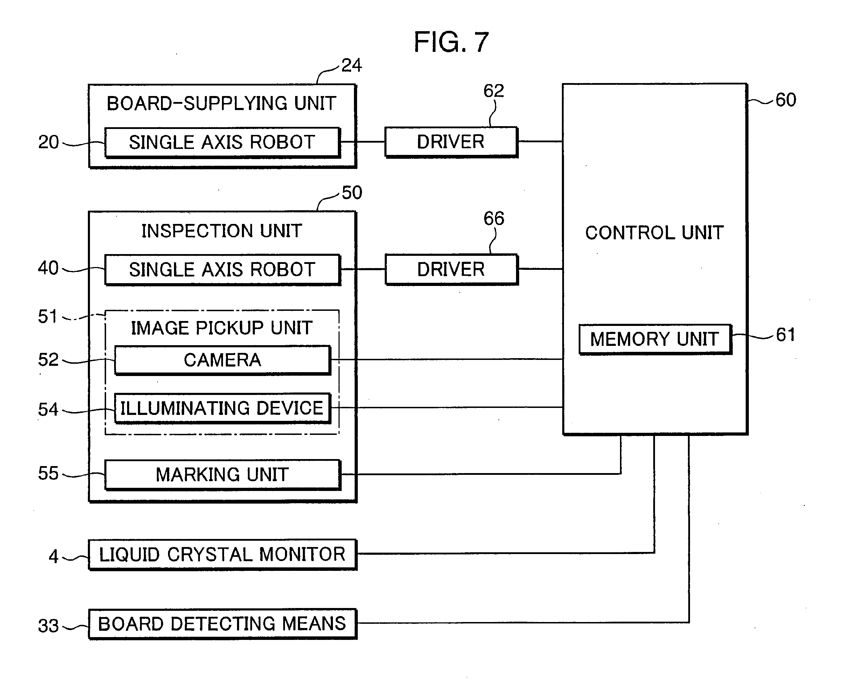

The control unit 60 comprises: a CPU that executes logical operations; a ROM storing various programs and the like for controlling the CPU; a RAM that temporarily stores various data during operation of the device; an HDD that stores various data and software, and the like. In addition, as shown in the block diagram in Figure 7, electrically connected to the control unit 60 are: the respective single axis robots 20 and 40 for the board-supplying unit 24 and for the inspection unit 50; the image pickup unit 51 (the camera 52 and the illuminating device 54); the marking unit 55; the liquid crystal monitor 4; and the board detector 33. Among the above, the single axis robots 20 and 40 are respectively connected to the control unit 60 via the drivers 62 and 66. In order to perform a series of inspection operations on the print board P according to a pre-stored operation program, the control unit 60 is configured so as to perform overall control of operations of the board-supplying unit 24, the inspection unit 50 and the like, and to perform operations such as judging whether the print board P is good or bad based on an image picked up by the camera 52 of the inspection unit 50 or, controlling display contents on the liquid crystal monitor 4 based on the judgment results.

With the inspection device 1 configured as described above, for example, an inspection of a print board P is executed as described below.

Upon activation, the inspection device 1 is kept in a stand-by state until a test is commenced. In this stand-by state, the table 30 of the board-supplying unit 24 is set at the home position and a predetermined menu screen is displayed on the liquid crystal panel 4.

In this state, as an operator manually sets the print board P onto the table 30 at the home position and performs a touch operation on the liquid crystal panel 4 to select "start inspection" from the menu screen, an inspection of the board P commences. The print board P is set on the table 30 by sandwiching the print board P between the board-holding frames 36 and 38 while arranging a face of the print board P subjected to inspection (the face on the side mounted with parts) to face upwards. At this point, positioning of the print board P is achieved by having the print board P abut the positioning plate 36a.

Once the inspection starts, upon confirming that the print board P has been set on the table 30 based on a detection signal of the board detector 33, the actuation of the single axis robot 20 of the board-supplying unit 24 causes the table 30 to move in the Y-axis direction and the print board P is positioned at the inspection position. Furthermore, the actuation of the single axis robot 40 of the inspection unit 50 causes the image pickup unit 51 to move in the X-axis direction. In response thereto, the camera 52 of the image pickup unit 51 is positioned at a position opposing the print board P, and under illuminating light from the illuminating device 54, an image of the print board P is picked up by the camera 52.

Images of the print board P are picked up by the camera 52 for each image pickup area preset according to various conditions such as the size of the print board P and the mounting state of parts thereon. In other words, according to the size of the print board P or the like, the face of the print board P to be inspected is divided into a plurality of image pickup areas, and images of the respective divided image pickup areas are to be sequentially picked up by the camera 52 that relatively moves in X and Y directions with respect to the print board P in association with the movement of the table 30 and the image pickup unit 51. Accordingly, images of the board P can be picked up with superior resolution even in a case of a large-size print board P or the like. Moreover, depending on the size of a print board P or the like, an overall image of the print board P can be picked up by a single image pickup process.

Once an image of the print board P is picked up by the camera 52, based on the picked-up image, the control unit 60 judges whether the appearance of the print board P (more specifically, the mounting state of parts on the print board P) is good or bad. When the judgment results in a bad board, the control unit 60 causes the liquid crystal panel 4 to display the image of the board P and further has the operator perform a visual judgment based on the image of the print board P displayed on the liquid crystal panel 4. Furthermore, when the print board P is once again judged to be a bad board by the visual judgment or, in other words, when the print board P is judged to be a bad board through both the automatic judgment by the control unit 60 and the visual judgment by the operator, only then is the print board P processed as a bad board. Specific contents of the good-bad judgment operation on the print board P by the control unit 60 will be described in detail later.

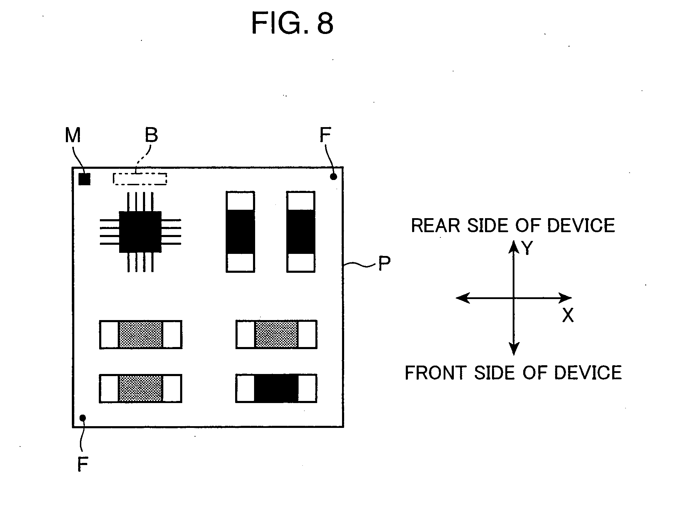

When an good-bad judgment operation of the print board P is concluded in this manner, the marking unit 55 positioned to a predetermined position above the print board P is actuated in association with movements of the table 30 and the image pickup unit 51 and, as shown in Figure 8, an inspection conclusion mark M, which indicates that the board P has already been inspected, is assigned to a predetermined location on an upper face (the inspected face) of the print board P. In the example shown in Figure 8, an inspection conclusion mark M is assigned to an edge (corner portion) of the print board P on the rear side of the device (the side of the inspection position) in a state where the print board P is set on the table 30. The print board P returns to the home position in accordance with the movement of the table 30 and the print board P is manually removed from the table 30 by the operator, thereby concluding the inspection of the board P. Subsequently, by repeatedly performing the inspection procedure described above, appearance inspections are executed in succession on a plurality of print boards P. Upon conclusion of an inspection, as the operator performs a predetermined touch operation on the liquid crystal panel 4, the display on the liquid crystal panel 4 returns to the menu screen and the inspection device 1 is reset to the stand-by state described earlier.

Meanwhile, it is likely that a print board P which is an object of inspection by the inspection unit 50 (i.e., an object of image pickup processing and the like by the camera 52) is a board that has already been inspected. In other words, a print board P once inspected by the inspection unit 50 may mistakenly be set once again to the board-supplying unit 24 by the operator, and when the inspection unit 50 performs another inspection of such an inspected board, the time required by the inspection operation is wasted by just that much. In consideration thereof, as a measure to prevent redundant inspections on the print board P by the inspection unit 50, the control unit 60 is configured so as to first confirm via the camera 52 whether the inspection conclusion mark M to be assigned to a print board P that has already been inspected exists or not, and only when it is found that the inspection conclusion mark M does not exist (in other words, the print board P has not yet been inspected), causes the inspection unit 50 to execute a series of inspection operations including picking up an image of the print board P (picking up an image of a mounting state of parts on the board P) using the camera 52. Conversely, when it is confirmed that the inspection conclusion mark M has been assigned to the print board P (in other words, the print board P has already been inspected), the control unit 60 causes the liquid crystal monitor 4 to display information to the effect that the print board P has already been inspected without having the inspection unit 50 execute an inspection operation of the print board P. In other words, history confirmer for confirming inspection history of the print board P depending on whether or not the inspection conclusion mark M exists, and controller for performing control, when the print board P is confirmed to be inspected, so as to cause the liquid crystal monitor 4 to display information to that effect and prohibiting execution of an inspection operation of the print board P by the inspection unit 50 are constituted by the control unit 60.

Next, specific contents of the good-bad judgment operation or the like by the control unit 60 will be described. When an image of the face of the print board P subjected to inspection is picked up by the camera 52, the control unit 60 first performs processing for comparing the picked-up image of the board P with standard image data to be used as a standard of a good board. More specifically, the control unit 60, having standard image data made up of one or more sample images of good boards stored in a memory unit 61 (Figure 7) provided internally, compares the standard image data with the picked-up image of the print board P by the camera 52 to determine a difference, and judges whether the print board P is good or bad based on the difference image. Extraction of the difference image is executed in a state where, for example, fiducial marks F (refer to Figure 8) for position alignment which are provided spaced at a plurality of locations on an upper face (the mounting face) of the print board P are matched between the picked-up image of the print board P and the standard image data in order to align the positions of both images.

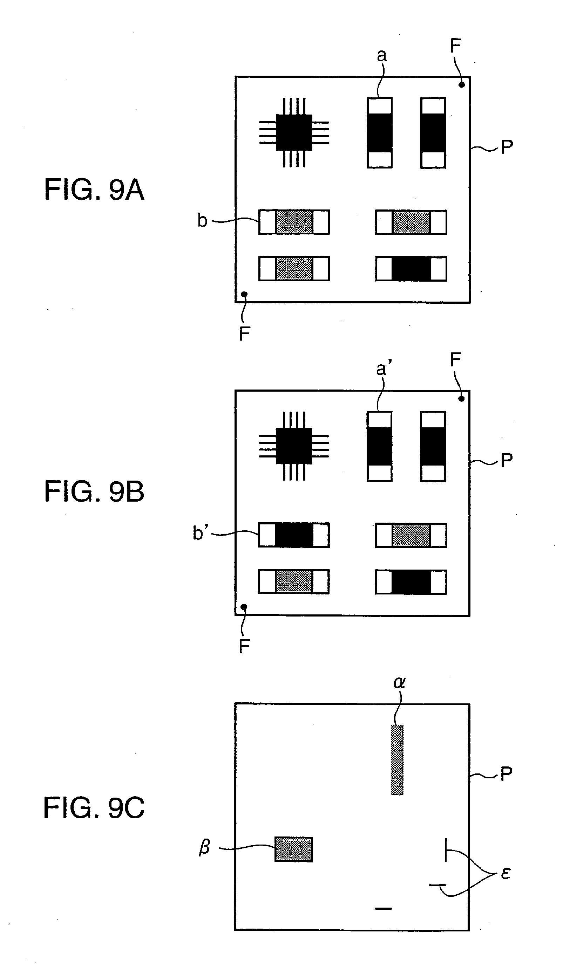

Figure 9A to 9C are diagrams for schematically explaining contents of image processing such as described above, wherein Figure 9A shows a picked-up image of the print board P picked up by the camera 52, Figure 9B shows standard image data, and Figure 9C shows a difference image obtained through image processing by the control unit 60. As shown in these drawings, various electronic parts are mounted on the print board P, and in a case where the mounting positions, types, or the like of the electronic parts differ between the picked-up image shown in Figure 9A and the standard image data shown in Figure 9B, a corresponding difference element is to be displayed in a difference image shown in Figure 9C. For example, since a misalignment exists between the mounting positions of an electronic part a shown in Figure 9A and an electronic part a' shown in Figure 9B, a difference element α corresponding to the displacement between the respective electronic parts a and a' is to be displayed in the difference image shown in Figure 9C. In addition, since an electronic part b shown in Figure 9A and an electronic part b' shown in Figure 9B differ from each other in part type, a difference element β corresponding to the difference in surface colors or the like between the respective electronic parts b and b' is to be displayed in the difference image shown in Figure 9C. Moreover, in addition to the difference elements α and β described above, the difference image shown in Figure 9C also displays minute difference elements such as that denoted by reference character ε.

Once having extracted a difference image such as that shown in Figure 9C through predetermined image processing, the control unit 60 next judges whether the area of each difference element (α, β and the like) is equal to or below a predetermined upper limit. If so, the control unit 60 judges that the print board P is a good board, and if not, the control unit 60 judges that the print board P is a bad board.

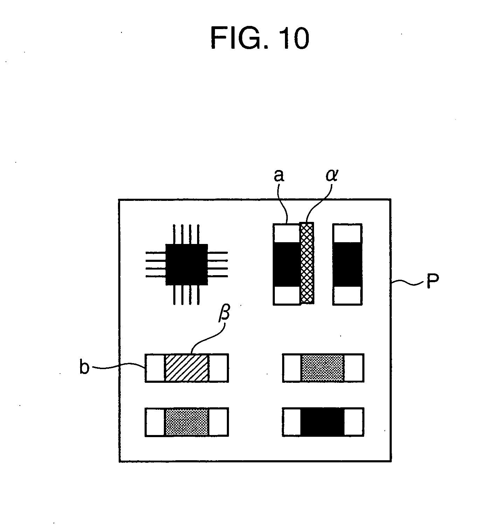

Figure 10 shows an image of the print board P displayed on the liquid crystal monitor 4 as an image for a visual judgment by the operator. As shown in the diagram, an image that combines the picked-up image of the print board P shown in Figure 9A and the difference image shown in Figure 9C is displayed on the liquid crystal monitor 4. In this case, the difference element whose area is equal to or smaller than the upper limit value (ε in Figure 9C) is omitted while difference elements α and β that are larger than the upper limit value are displayed colored in different colors in accordance with characteristics of the differences. This is a measure to further facilitate visual judgment by the operator, and coloring is applied so that, for example, the difference element α attributable to the position displacement of electronic parts is colored in blue, the difference element β attributable to the difference in type of electronic parts is colored in red, and so on. The operator performs a visual judgment of the print board P while viewing such a display screen of the liquid crystal monitor 4, and inputs results thereof through touch operations of the liquid crystal monitor 4.

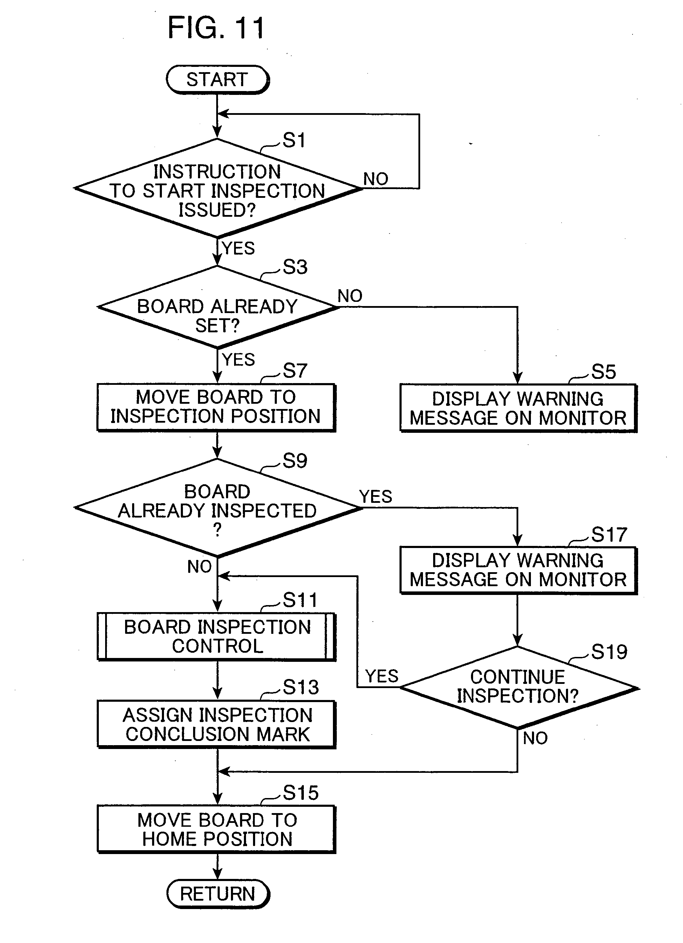

Next, a control operation by the control unit 60 in the inspection device 1 configured as described above will be described with reference to the flowcharts shown in Figures 11 to 12. As the control operation commences, the control unit 60 waits for a touch operation to be performed by the operator on the liquid crystal monitor 4 to input an instruction to start an inspection (step S1), and judges whether or not the print board P has been set on the table 30 of the board-supplying unit 24 or, in other words, whether or not the print board P has been manually set by the operator onto the table 30 at the home position (refer to the solid line in Figure 3) (step S3). More specifically, by confirming whether or not the detection signal of the board detector 33 has been switched from OFF to ON before the instruction to start an inspection is inputted in step S1, a judgment is made on whether the print board P has been set on the table 30 or not. Subsequently, when it is confirmed that NO has been judged in step S3 or, in other words, it is confirmed that the print board P is not set on the table 30 (the detection signal is OFF) or a previously inspected board P has not been replaced and remains on the table 30 (the detection signal remains unchanged at ON), control is executed so as to display a warning message on the liquid crystal monitor 4 to prompt the operator to newly set the print board P (or to replace and set a different print board P) (step S5).

On the other hand, when YES is judged in step S3 and it is confirmed that the print board P is properly set on the table 30, control is executed so as to actuate the single axis robot 20 to move the table 30 in a Y-axis direction, and in response thereto, move the print board P to the inspection position indicated by the dashed-two dotted line shown in Figure 3 (step S7). The flow then proceeds to a next step S9 to judge whether the print board P has already been inspected or not. More specifically, in accordance with the actuation of the single axis robot 40, by moving the camera 52 of the image pickup unit 51 in an X-axis direction and moving, as necessary, the table 30 in a Y-axis direction, a judgment is made on whether the print board P has already been inspected or not by positioning the camera 52 above a portion on the print board P to which an inspection conclusion mark M (Figure 8) is assigned and confirming through the camera 52 as to whether the inspection conclusion mark M exists or not.

When NO is judged in step S9 and it is confirmed that the print board P has not been inspected, the flow proceeds to board inspection control for performing operations such as picking up an image of the print board P and judging whether the print board P is good or bad (step S11). Specific contents of this board inspection control will be described in detail later. Subsequently, when the board inspection control is concluded and the inspection operation on the print board P is completed, the control unit 60 executes control for actuating the marking unit 55 to assign an inspection conclusion mark M on the print board P (step S13) and then actuating the single axis robot 20 to move the table 30 in the Y-axis direction to restore the print board P on the table 30 to the home position at which the print board P can be attached/detached by the operator (step S15).

On the other hand, when YES is judged in step S9 and it is confirmed that the print board P has already been inspected or, in other words, when it is confirmed that the print board P which has already been inspected is once again set to the board-supplying unit 24, control is executed so as to cause a warning message to the effect that the print board P has already been inspected to be displayed on the liquid crystal monitor 4 (step S17). At this point, the liquid crystal monitor 4 is arranged to concurrently display a selection screen for issuing an instruction on whether or not inspection is to be continued. This is done in consideration of the fact that there may be cases where, for some reason or other, the operator desires to reinspect a print board P that has already been inspected, and to confirm such an intent of the operator. Subsequently, a judgment is made on whether an instruction for continuing inspection has been inputted or not by a selection operation of the liquid crystal monitor 4 (step S19), and when YES is judged to confirm that an instruction for continuing inspection has been issued, the flow proceeds to step S11 to execute board inspection control. On the other hand, when NO is judged in step S19 to confirm that an instruction for terminating inspection has been inputted, the flow proceeds to step S15 without executing board inspection control, and executes control for restoring the print board P to the home position.

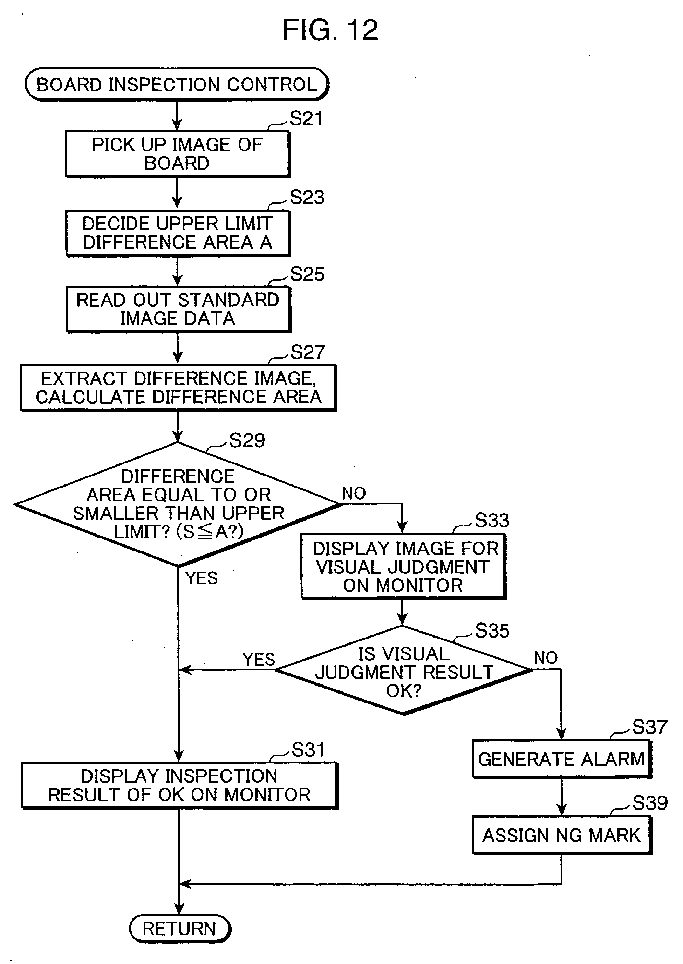

Figure 12 is a subroutine showing specific contents of board inspection control of step S11 in Figure 11. As the subroutine commences, the control unit 60 executes control for picking up an image of the print board P using the camera 52 of the image pickup unit 51 (step S21). More specifically, the single axis robot 40 is actuated to position the image pickup unit 51 above the print board P that is at the inspection position and an illuminating light is irradiated by the illuminating device 54 to illuminate the print board P. In this state, a control signal is outputted to the camera 52 to cause the same to pick up an image of the print board P. Then, control is executed for deciding, according to the size of the picked-up image of the print board P or the like, an upper limit difference area A to be used as a standard in a subsequent step when judging whether the print board P is good or poor (step S23).

Next, the control unit 60 reads out standard image data to be used as a standard of a good board from the memory unit 61 (step S25), and executes control for extracting a difference image such as shown in Figure 9C and calculating an area s of each difference element (α or β in Figure 9C) by comparing the standard image data with a picked-up image of the print board P obtained in step S21 and determining a difference thereof (step S27).

The control unit 60 then judges whether the area s of each difference element (hereinafter abbreviated to difference area s) is equal to or smaller than the upper limit difference area A calculated in step S23 (step S29), and when YES is judged at this point to confirm that the difference area s is equal to or smaller than the upper limit difference area A or, in other words, when it is judged that a defect such as a significant positional displacement of electronic parts on the print board P does not exist, the flow proceeds to a subsequent step S31 to execute control for displaying information to the effect that the inspection result is good on the liquid crystal panel 4. Moreover, when an image of the print board P is picked up for each of a plurality of areas as described above, the judgment processing of the difference area s in step S29 is to be performed for each image pickup area. In this case, a YES judgment is to be made in step S29 when it is confirmed for all image pickup areas that the difference area s is equal to or smaller than the upper limit difference area A. Furthermore, in step S29, in the event that a plurality of pieces of the standard image data exists, when it is confirmed through a comparison with any of the plurality of pieces of standard image data that the difference area s is equal to or smaller than the upper limit difference area A, the print board P is judged to be a good board (YES in step S29). Conversely, in step S29, a NO judgment is made only when it is confirmed in comparisons with all of the plurality of pieces of standard image data that the difference area s is greater than the upper limit difference area A.

In the case where NO is judged in step S29 and the area s of the difference element is confirmed as being greater than the upper limit difference area A or, in other words, when it is confirmed that a defect such as a significant position displacement of electronic parts may exist, the flow proceeds to a next step S33 to execute control so as to cause the liquid crystal monitor 4 to display an image for visual judgment by the operator. More specifically, an image (refer to Figure 10) which combines the difference image extracted in step S27 with the picked-up image of the print board P picked up by the camera 52 and further performing thereon coloring processing (processing in which difference elements are colored in colors corresponding to difference characteristics) such as described and the like is displayed on the liquid crystal monitor 4. Then, the control unit 60 judges whether the result of a visual judgment performed based on the image displayed on the liquid crystal monitor 4 is a good board or not (step S35). More specifically, a judgment is made on whether or not an operation signal indicating that the judgment result is a good board has been inputted via the liquid crystal panel 4 by a touch operation of the same performed by the operator.

Subsequently, when YES is judged in step S35 to confirm that the result of the visual judgment by the operator is a good board, the flow proceeds to step S31 to execute a control for displaying information to the effect that the inspection result was a good board on the liquid crystal monitor 4. On the other hand, when NO is judged in step S35 to confirm that the result of the visual judgment by the operator is a bad board, a warning alarm is activated (step S37) and, at the same time, a control is executed in which the marking unit 55 is actuated to assign an NG mark (not shown) indicating that a print board P is a bad board to the print board P (step S39). Moreover, since an inspection conclusion mark M can be arranged to double as an NG mark by altering the types of inspection conclusion marks M to be assigned to the print board P in step S13 of Figure 11 between cases where the print board P is good and cases where the print board P is bad, the processing of step S39 can be omitted.

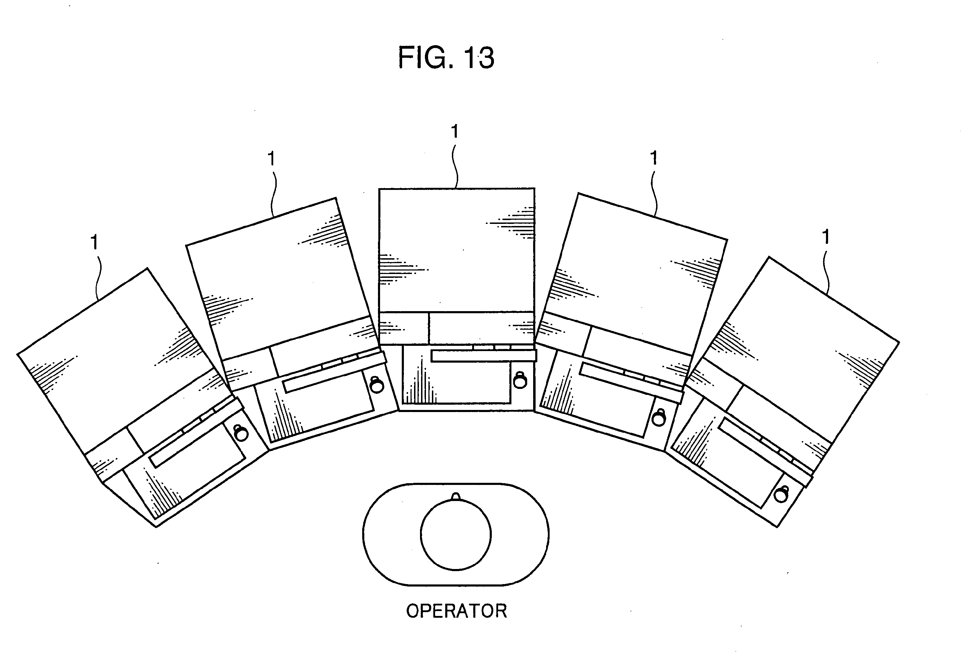

Since an appearance inspection of a print board P which is performed based on control operations such as described above requires a certain amount of time, normally, an inspection of print boards P is performed by aligning a plurality of the inspection devices 1 and setting a time difference to each inspection device 1. This enables a single operator to carry out inspections of print boards P in an efficient manner. In this case, as shown in Figure 13, the operator is now capable of performing an inspection more efficiently by arranging a plurality of (five in the illustrated example) inspection devices 1, 1, ... in a fan-shaped alignment. In other words, since the inspection device 1 is formed as described above such that the width of the front-side portion 2B tapers forward, by arranging the respective inspection devices 1, 1, ... with this portion abutting against each other, the plurality of inspection devices 1, 1, ... can be arranged in a fan-like shape around a position at which the operator stands.

As described above, since the inspection device 1 comprises: an inspection unit 50 for inspecting a print board P; a board-supplying unit 24 that enables a print board P to be manually supplied to the inspection unit 50; and a liquid crystal monitor 4 for displaying prescribed information including the results of an inspection of the print board P, and is further provided with: a control unit 60 that controls, when it is confirmed that the print board P has already been inspected based on an inspection conclusion mark M assigned to the print board P, the liquid crystal monitor 4 to display information to that effect and prohibit execution of an inspection operation of the print board P by the inspection unit 50 (a series of operations such as picking up an image of the print board P by a camera 52), it is now possible to reliably prevent inspections from being redundantly performed on the same print board P and to efficiently perform board inspections while avoiding occurrences of time loss due to redundant inspections.

In other words, with the inspection device 1, control is performed such that when the print board P is conveyed by the part-supplying unit 24 and reaches an inspection position, the camera 52 immediately checks whether an inspection conclusion mark M exists on the print board P, and operations such as pickup of an image of the print board P by the camera 52 (pickup of a mounting state of parts on the print board P) and image processing on the image are executed only when it is confirmed that the inspection conclusion mark M does not exist or, in other words, that the print board P has not yet been inspected. Consequently, an inspection will not be redundantly performed by the inspection unit 50 on a print board P that has already been inspected, and occurrences of time loss due to the same board P being redundantly inspected can be effectively avoided.

In particular, in a case where an inspection of a print board P is performed using a plurality of inspection devices 1 as shown in Figure 13, while it is conceivable that mistakes in which a print board P that has already been inspected is accidently set once again on the inspection device 1 (the board-supplying unit 24 thereof) will relatively increase, by adopting the configuration described above in such a usage state, it is now possible to perform a more efficient inspection of the print board P while effectively avoiding occurrences of time loss.

In addition, since the inspection device 1 is configured such that, upon conclusion of an inspection of a print board P, an inspection conclusion mark M indicating that the print board P has already been inspected is assigned to the print board P in accordance with the actuation of the marking unit 55, an advantage may be achieved in that whether or not the print board P has already been inspected can be judged by a single configuration of merely checking the existence or absence of the inspection conclusion mark M.

Furthermore, since the inspection device 1 is configured so as to reciprocatingly move a print board P between a home position at which attaching and detaching of the print board P can be performed and an inspection position at which an inspection of the print board P is performed by the inspection unit 50 in accordance with the actuation of the board-supplying unit 24, and is configured such that merely setting the print board P to the home position of the board-supplying unit 24 causes a subsequent series of operations or, in other words, operations such as moving the print board P to the inspection position or restoring the inspected print board P to the home position to be automatically executed, usability of the inspection device can be effectively improved.

Moreover, since the inspection device 1 is configured so as to check whether a print board P has already been inspected or not when the board P is conveyed to the inspection position by the board-supplying unit 24, and when it is confirmed that the print board P has already been inspected, after performing a predetermined operation such as displaying a warning message on the liquid crystal monitor 4, immediately actuate the board-supplying unit 24 and move (restore) the print board P to the home position, an advantage may be achieved in that the duration of a time loss that occurs when an inspected print board P is mistakenly set to the board-supplying unit 24 can be minimized and a decline in operating efficiency of board inspection can be effectively suppressed.

In addition, since the inspection device 1 is configured such that an operation by the board-supplying unit 24 for moving a print board P at the inspection position to the home position is executed only after confirming that an instruction to continue inspection from the operator does not exist (the operator has inputted via the liquid crystal monitor 4 an instruction to the effect that the inspection is to be terminated), an advantage may be achieved in that the inspection of a print board P can be appropriately terminated or continued depending on the intention of the operator.

Furthermore, since the inspection device 1 is configured such that an operation by the board-supplying unit 24 for moving a print board P set to the home position to the inspection position is executed only after confirming the existence of the print board P by board detector 33 provided on the board-supplying unit 24, the execution of a conveying operation of the print board P by the board-supplying unit 24 to the inspection position in a state in which the print board P is not set to the home position (a state in which the operator has forgotten to set the board P) can be prevented and an occurrence of a time loss due to such a conveying operation can be reliably avoided.

Moreover, since the inspection device 1 is configured such that various portions including the inspection unit 50, the board-supplying unit 24, and the liquid crystal panel 4 are integrally assembled on common frame members (i.e., the base frame 10, the subframes 16 and 18, the beam 19 and the like) so as to be desktop-mountable, an advantage may be achieved in that the space occupied by the inspection device 1 can be minimized and the inspection device 1 can be used anywhere without discrimination. For example, with a conventional inspection device of this type (Patent Document 1 described in Background Art), since the inspection device is comprised of two separate and independent units, namely, a testing unit and a main unit, and the main unit further comprises a desktop personal computer, it was practically impossible to compactly arrange a plurality of inspection devices within a small space. However, with the inspection device 1 according to the above embodiment, it is now possible to eliminate such inconveniences and compactly arrange a plurality of the inspection devices 1 within a small space. In particular, by placing the liquid crystal panel 4 approximately midway in a front-rear direction between an image pickup position (inspection position) by the image pickup unit 51 and an inlet/outlet 6, and to the front of the image pickup unit 51, the inspection device 1 is configured so that the liquid crystal panel 4 is less likely to project itself towards the side (in the width direction) of the device. Consequently, since there are no such projections, the space occupied by the inspection device 1 itself can be reduced in a width-direction and a plurality of the inspection devices 1 abutting each other can be arranged side by side. In this case, since the plurality of inspection devices 1 can be arranged and placed in a fan-like shape around the standing position of the operator as described above, the plurality of inspection devices 1 can now be compactly disposed and the access distance of the operator to each of the inspection devices 1 can be made approximately uniform.
As a result, an advantage may be achieved in comparison with a case where inspection devices are arranged side-by-side in a straight line in that inspection operations can now be performed efficiently within a limited space.

In addition, since the inspection device 1 is configured such that while a print board P is to be conveyed between a position opposing the inlet/outlet 6 and an inspection position by the board-supplying unit 24, the inspection position is provided above the inlet/outlet 6 to convey the print board P in an oblique direction as described above, the space occupied by the board-supplying unit 24 in a front-rear direction is reduced compared to a case where the print board P is conveyed over the same distance in a horizontal direction. As a result, the space occupied by the inspection device 1 can be reduced in the front-rear direction.
Furthermore, since the control unit 60 is disposed in a space 15 with a triangular cross-section provided below the board-supplying unit 24 (the single axis robot 20) using the configuration in which the print board P is conveyed in an oblique direction as described above, the control unit 60 can be rationally incorporated into the inspection device 1 without having to separately provide placement space. Consequently, an advantage may be achieved in that the space occupied by the inspection device 1 is further reduced. In addition, since the control unit 60 will be disposed in a robust space inside the base portion 12 in this case, another advantage may be achieved in protecting the unit 60.

Moreover, since the board-supplying unit 24 supports a print board P with the table 30 and conveys the print board P in an inclined posture in which a face of the print board P to be inspected becomes parallel to an inclined face 12a of the base frame 10 (parallel to the conveying direction of the print board P) or, in other words, conveys the print board P in a state where a rear side is raised, the rear side of the board P is given favorable visibility even when setting the print board P on the table 30 at the inlet/outlet 6. Therefore, an advantage may be achieved in that the print board P can be securely and accurately set on the table 30 while performing visual confirmation, and an inspection can be effectively prevented from proceeding in a state where the print board P is incompletely set.

It should be noted that the inspection device 1 described above is an example of a preferable embodiment according to the present invention, and specific configurations thereof can be varied without departing from the scope of the present invention.

For example, in the above embodiment, while an operation for confirming whether or not there is an inspection conclusion mark M on the print board P (an operation for confirming whether the mark M exists or not by the camera 52) is executed after the print board P moves to the inspection position indicated by the dashed-two dotted line in Figure 3, a confirmation operation of the inspection conclusion mark M may be arranged to be executed before movement of the print board P to the inspection position is completed (in a state where the board P is located between the home position and the inspection position). At this point, by immediately restoring the print board P to the home position upon confirmation of the existence of the inspection conclusion mark M, the duration of a time loss that occurs when mistakenly setting an inspected print board P can be further shortened. In particular, as shown in Figure 8, in the case where an inspection conclusion mark M is assigned to an end portion on the inspection position side of the print board P set on the table 30, since the existence of the inspection conclusion mark M can be confirmed by the camera 52 at the point where the end portion on the inspection position side of the print board P reaches underneath the image pickup unit 51, the distance over which the print board P must be moved to a position that enables confirmation of the inspection conclusion mark M can be further reduced and the loss time can be further effectively shortened.

In addition, in the above embodiment, while an identification conclusion mark M to be assigned to a print board P that has already been inspected is used as identification information for judging whether a print board P has already been inspected or not (in other words, confirming inspection history of the print board P), for example, as indicated by the dashed-two dotted line in Figure 8, when an ID code B capable of individually identifying print boards P is assigned to each board P, the ID code B can be used as the identification information. In other words, for example, by storing an ID code B and inspection history of a print board P in association with each other in the memory unit 61 (memory) of the control unit 60 and collating an ID code B acquired through the camera 52 against history information in the memory unit 61, it is possible to reliably judge whether or not a print board P, which is currently an inspection object, has already been inspected.

Furthermore, in the above embodiment, while an optical sensor is used as board detector 33 that detects whether or not a print board P has been set on the table 30 of the board-supplying unit 24, the board detector 33 need only be capable of detecting whether the print board P exists or not and, for example, the camera 52 may double as the board detector 33. More specifically, by attaching a white plate that differs in color from its surroundings to the plate 32 of the table 30, the existence of the print board P can be confirmed based on whether the white plate has been recognized by the camera 52 or not. In other words, while an image of the white plate on the table 30 is picked up and the luminance of the picked-up image increases when a print board P has not been set, once the print board P is set, the white plate is shielded and the luminance of the picked-up image decreases. The print board P can then be detected by the difference in such luminance of the image.

Moreover, while the above embodiment is arranged so as to generate a warning alarm when a print board P is judged to be a bad board through a visual judgment by the operator (when it is confirmed that the print board P is a bad board), an alarm can be appropriately generated at timings other than the above. For example, a brief alarm may be generated when the print board P is returned to the home position after the inspection is concluded in order to prompt the operator to retrieve the print board P, or a brief alarm may be generated when the print board P is judged to be a bad board through an automatic judgment by the control unit 60 in order to prompt the operator to perform a visual judgment on the print board P. When generating alarms at a plurality of timings as described above, the operator will be able to readily understand the meaning of the alarms by varying the lengths and sounds of the alarms depending on the timings.

In addition, in the above embodiment, while the inspection device 1 is configured so as to be left-right asymmetrical with only a lateral face portion on one side of the front-side portion 2B inclined in a front-rear direction, the inspection device 1 may alternatively be configured so as to be left-right symmetrical with both lateral face portions of the front-side portion 2B inclined. According to this configuration, the curvature of a fan-shaped array of a plurality of the inspection devices 1 as shown in Figure 13 can be increased.

Furthermore, while the above embodiment is configured such that only the front-side portion 2B of lateral-face portions of the inspection device 1 is inclined, a configuration is obviously also possible in which a continuous inclined face is formed across the rear-side portion 2A and the front-side portion 2B. In this case, similar to described above, the inspection device 1 may alternatively be configured so as to be left-right symmetrical with both lateral face portions inclined. According to this configuration, when arranging a plurality of the inspection devices 1 in a fan-like shape as shown in Figure 13, it is now possible to bring adjacent inspection devices 1 into close contact with each other. However, with this configuration, since it is conceivable that an increase in the inclined portion among lateral-face portions of the inspection device 1 causes the internal spaces of the inspection devices 1 to decrease in comparison with that of the above embodiment, when incorporating components such as the board-supplying unit 24 with a certain amount of latitude, the inclined portion among the lateral-side portions is preferably minimized.

Moreover, in the above embodiment, while the board-supplying unit 24 is configured such that the table 30 moves in an inclined direction with respect to a horizontal plane, a configuration is also possible in which the table 30 moves in a horizontal direction. In addition, while the above embodiment is arranged such that the print board P is set on the table 30 so that the face of the print board P to be inspected faces upward and images of the face to be inspected are picked up by the image pickup unit 51 from above the print board P, for example, the board-supplying unit 24, the image pickup unit 51 and the like may be configured such that the print board P is set on the table 30 so that the face of the print board P to be inspected faces sideways (leftward or rightward in Figure 4) and an image of the face to be inspected is picked up by the image pickup unit 51 from that side.

Furthermore, in the above embodiment, while the board-supplying unit 24 is configured so as to hold the print board P in an inclined posture in which the face to be inspected becomes parallel to the inclined face 12a of the base frame 10 (approximately parallel to the conveying direction of the print board P) and the print board P is conveyed in this state, for example, the board-supplying unit 24 may alternatively be configured so as to hold the print board P in a horizontal posture and, while maintaining the posture, convey the print board P along the inclined face 12a in an inclined direction.

Moreover, while the above embodiment is arranged so that in order to pick up an image of a print board P at an arbitrary position by the image pickup unit 51, the table 30 is moved in a Y-axis direction and the image pickup unit 51 is moved in an X-axis direction, whereby the mutual movements enable the image pickup unit 51 to be positioned at an arbitrary position on the print board P, as a matter of course, a configuration is also possible in which one of the print board P and the image pickup unit 51 is immobilized and only the other is moved in both X-axis and Y-axis directions.

In addition, in the above embodiment, as shown in Figure 3, while the liquid crystal panel 4 is placed in front of the image pickup unit 51, the liquid crystal panel 4 may alternatively be placed above the image pickup unit 51 (on the upper-face cover Ca1). More specifically, the liquid crystal panel 4 may be placed above the beam 19. Whatever the configuration, the liquid crystal panel 4 can be suppressed from projecting towards the device (in the width-direction).

Furthermore, in the above embodiment, while the liquid crystal panel 4 is assembled on a tip of a beam 19 extending in a front-rear direction, for example, a gate-shaped frame straddling the board-supplying unit 24 may be provided in front of the image pickup unit 51 and the liquid crystal panel 4 assembled on the frame. However, a configuration in which the liquid crystal panel 4 is assembled on a tip of the beam 19 as is the case with the above embodiment, there is an advantage in that the internal space of the inspection device 1 can be effectively utilized in comparison to the case where a gate-shaped frame is provided as described above.

Moreover, with the above embodiment, due to the configuration in which a print board P is conveyed in an inclined direction and an image of the print board P is picked up from above, a relatively wide space is formed behind the image pickup unit 51. Therefore, while a driver 66 that performs drive control of the inspection unit 50 (the single axis robot 40) is disposed in this space, the driver 66 may be included in the control unit 60 to be integrally disposed in the space 15 inside the base frame 10. However, according to a configuration in which the driver 66 is placed behind the image pickup unit 51 as is the case with the above embodiment, an advantage may be achieved in that the wide space behind the image pickup unit 51 can be utilized efficiently and the wiring distance of a wire harness or the like connecting the single axis robot 40 with the driver 66 can be shortened.

In addition, in the above embodiment, while the control unit 60 is disposed in a depression formed at the base portion 12 of the base frame 10, for example, a hollow portion may be formed at the base portion 12 whereby the control unit 60 is disposed inside the hollow portion.

Moreover, boards to become objects of inspection of the inspection device according to the present invention need not be limited to print boards, and may instead be, for example, boards in which a circuit is formed on a lead frame.

The present invention described heretofore may be summarized as follows.

That is, a board inspection device according to the present invention comprises: an inspection unit for inspecting a board; a board-supplying unit that enables a board to be manually supplied to the inspection unit; and display for displaying prescribed information including the results of the inspection of the board, wherein the board inspection device is further provided with: recognizer for recognizing identification information assigned to the board; history confirmer that acquires identification information of the board via the recognizer and confirms inspection history of the board based on the identification information; and controller that controls, when it is confirmed by the history confirmer that the board has already been inspected, the display to display information to the effect that the board has already been inspected and prohibits execution of an inspection operation on the board by the inspection unit.

According to this inspection device, due to a configuration in which a board supplied manually via the board-supplying unit is inspected by the inspection unit and a result of the inspection is displayed on the display, when it is confirmed that the board has already been inspected based on identification information assigned to the board, the display is controlled so as to display information to that effect and the inspection unit is prohibited from executing an inspection operation on the board. Consequently, inspections are reliably prevented from being redundantly performed on the same board and, as a result, board inspections can now be efficiently performed while avoiding occurrences of time loss due to redundant inspections.

More specifically, in the above configuration, marking device that assigns, when an inspection by the inspection unit is concluded, an inspection conclusion mark indicating that a board has already been inspected as the identification information to the board is further provided, wherein the history confirmer confirms inspection history of the board by judging whether or not the inspection conclusion mark exists via the recognizer.

According to this configuration, the inspection history of a board can be confirmed by a simple configuration of merely checking whether an inspection conclusion mark exists or not.

In addition, as an embodiment that differs from the above configuration, memory that stores an ID code assigned to a board as identification information and inspection history of the board in association with each other is further provided, wherein the history confirmer confirms inspection history of the board by collating the ID code acquired via the recognizer with history information stored in the memory.

According to this configuration, an advantage may be achieved in that by collating an ID code assigned to a board with history information in the memory, inspection history of the board can be reliably confirmed.

Furthermore, the board-supplying unit is configured so as to reciprocatingly move a board between a home position at which attaching and detaching of the board can be performed manually and an inspection position at which an inspection of the board is to be performed by the inspection unit.

According to this configuration, since merely setting the board to the home position of the board-supplying unit causes a subsequent series of operations or, in other words, operations such as movement of the board to the inspection position or restoration of the board inspected at the inspection position to the home position to be automatically executed, the usability of the inspection device can be effectively improved.

In addition, the history confirmer is configured so as to acquire identification information of a board via the recognizer at the point where the board is conveyed to the inspection position, and the board-supplying unit is configured so as to move the board at the inspection position to the home position when it is confirmed by the history confirmer that the board has already been inspected.

According to this configuration, the duration of a time loss that occurs when an inspected board is mistakenly set to the board-supplying unit can be minimized and a decline in operation efficiency of board inspection can be effectively suppressed.

In this case, the controller is configured so as to cause the board-supplying unit to execute an operation for moving a board at the inspection position to the home position only after confirming that an instruction of inspection continuation has not been issued by the operator.

According to this configuration, the inspection of a board can be appropriately terminated or continued depending on the intention of the operator.

Furthermore, in the above configuration, board detector that detects whether or not a board has been set to the home position of the board-supplying unit is further provided, wherein the control unit is configured so as to prohibit a conveying operation by the board-supplying unit to the inspection position when a board is not detected by the board detector.

According to this configuration, the board-supplying unit can be prevented from being actuated in a state where a board is not set (a state in which the operator has forgotten to set a board), and occurrences of time loss attributable thereto can be reliably avoided.

Moreover, in a inspection device such as described above, the respective portions including the inspection unit, the board-supplying unit and the display are integrally assembled and configured so as to be desktop-mountable.

According to this configuration, the space occupied by the inspection device can be reduced and the inspection device can be used anywhere without discrimination.

### Industrial Applicability

As described above, the board inspection device according to the present invention is capable of reliably preventing inspections from being redundantly performed on the same board and efficiently performing board inspections while avoiding occurrences of time loss due to such redundant inspections, and is particularly useful in the manufacturing field of boards mounted with parts.

## Claims

1. A board inspection device comprising: an inspection unit for inspecting a board; a board-supplying unit that enables a board to be manually supplied to the inspection unit; and a display for displaying prescribed information including the results of the inspection of the board, wherein the board inspection device is further provided with:
a recognizer for recognizing identification information assigned to the board;
a history confirmer that acquires identification information of the board via the recognizer and confirms inspection history of the board based on the identification information; and
a controller that controls, when it is confirmed by the history confirmer that the board has already been inspected, the display to display information to the effect that the board has already been inspected and prohibits execution of an inspection operation on the board by the inspection unit.

2. The board inspection device according to claim 1, further comprising:
a marking device that assigns, when an inspection by the inspection unit is concluded, an inspection conclusion mark indicating that a board has already been inspected as the identification information to the board, wherein
the history confirmer confirms inspection history of the board by judging whether or not the inspection conclusion mark exists via the recognizer.

3. The board inspection device according to claim 1, further comprising:
a memory that stores an ID code assigned to a board as the identification information and inspection history of the board in association with each other, wherein
the history confirmer confirms inspection history of the board by collating the ID code acquired via the recognizer with history information stored in the memory.

4. The board inspection device according to claim 1, wherein
the board-supplying unit is configured so as to reciprocatingly move a board between a home position at which attaching and detaching of the board can be performed manually and an inspection position at which an inspection of the board is to be performed by the inspection unit.

5. The board inspection device according to claim 4, wherein
the history confirmer acquires identification information of a board via the recognizer at the point where the board is conveyed to the inspection position, and
the board-supplying unit moves the board at the inspection position to the home position when it is confirmed by the history confirmer that the board has already been inspected.

6. The board inspection device according to claim 5, wherein
the controller causes the board-supplying unit to execute an operation for moving a board at the inspection position to the home position only after confirming that an instruction of inspection continuation has not been issued by the operator.

7. The board inspection device according to any one of claims 4 to 6, further comprising:
a board detector that detects whether or not a board has been set to the home position of the board-supplying unit, wherein
the controller prohibits a conveying operation by the board-supplying unit to the inspection position when a board is not detected by the board detector.

8. The board inspection device according to claim 1, wherein
the respective portions including the inspection unit, the board-supplying unit and the display are integrally assembled and configured so as to be desktop-mountable.
